Europäisches Patentamt

European Patent Office

Office européen des brevets

(19)

(11) EP 0 633 477 B1

(12) **FASCICULE DE BREVET EUROPEEN**

(45) Date de publication et mention
de la délivrance du brevet:
**17.10.2001 Bulletin 2001/42**

(51) Int Cl.⁷: **G01R 27/28**, G01R 25/02, G01R 25/04

(21) Numéro de dépôt: **94401564.3**

(22) Date de dépôt: **07.07.1994**

(54) **Dispositif de mesure vectorielle de signaux hyperfréquences de même pulsation, de type jonction à six portes**

Vektormessanordnung mit Sechs-Tor-Koppler für Ultrahochfrequenzsignale gleicher Frequenz

Vector measuring appliance for ultra-high frequency signals of the same frequency, of the six-port type

(84) Etats contractants désignés:
**DE GB**

(30) Priorité: **09.07.1993 FR 9308465**

(43) Date de publication de la demande:
**11.01.1995 Bulletin 1995/02**

(73) Titulaire: **FRANCE TELECOM**
**75015 Paris (FR)**

(72) Inventeurs:
• **Huyart, Bernard**
  **F-77185 Lognes (FR)**
• **Wiedmann, Frank**
  **D-71665 Vaihingen (DE)**

(74) Mandataire: **Dubois-Chabert, Guy et al**
**BREVALEX**
**3, rue du Docteur Lanceraux**
**75008 Paris (FR)**

(56) Documents cités:
**US-A- 4 001 681**

• **MICROWAVE JOURNAL, vol.34, no.11, Novembre 1991, NORWOOD,MA,US pages 102 - 114, XP000275405 KAMAREI 'vector voltmeter applications in microwave imaging'**
• **1980 IEEE MTT-S INT. MICROWAVE SYMPOSIUM DIGEST, PISCATAWAY,NEW-YORK,US pages 431 - 433 RIBLET 'transmission phase measurements with a single six-port.'**

**Description**

Domaine technique

La présente invention concerne une dispositif de mesure vectorielle de signaux hyperfréquences de même pulsation, de type jonction à six accès. Un tel dispositif peut être réalisé en technologie monolithique intégrée micro-onde (MMIC) ou hybride intégrée micro-onde (MHMIC).

Etat de la technique

Des dispositifs de mesure de type "six accès" sont décrits dans les trois articles suivants :

- un article de B. Huyart, H. Richard, E. Bergeault, L. Jallet, Y. Delisle, R.G. Bosisio, intitulé "Dispositif de mesure intégré", (Actes de la Conférence des huitièmes journées nationales micro-ondes, JNM 1993, Brest, 12-14 mai 1993);
- un article de M.N. Solomon, P.S. Weitzman, C.P. McClay et H.M. Cronson, intitulé "A Monolithic Six-Port Module" (IEEE Microwave and Guided Wave Letters, vol. 2, n° 8, août 1992) ;
- un article de V. Bilik, V. Raffay et I. Bezek, intitulé "A New Extremely Wideband Lumped Six-Port Reflectometer", (EUMC 91, septembre 1991).

Les dispositifs de l'art connu décrits dans les deux premiers articles de B. Huyart et al. et de M.S. Solomon et al. utilisent essentiellement des composants réactifs (inductances, capacité) pour réaliser une jonction à six accès. En technologie MMIC, la bande passante du dispositif se trouve alors réduite et égale approximativement à 10% de la fréquence centrale de fonctionnement. En technologie hybride MHMIC, il est possible d'obtenir de larges bandes passantes, mais dans ce cas la dimension du circuit est grande.

L'autre dispositif décrit dans le troisième article cité, de V. Bilik, utilise essentiellement des composants passifs (résistances) pour réaliser une jonction à six accès. En conséquence, la bande passante est grande (plusieurs décades) et le dispositif est facilement intégrable. Ce dispositif présente cependant les inconvénients suivants :

- ce dispositif présente des pertes typiques entre les deux accès de mesure des signaux hyperfréquences qui sont de l'ordre de 14 dB et entre ces mêmes accès et les quatre autres, où sont connectées les diodes de détection, qui sont de l'ordre de 16 dB ;
- ce dispositif est très sensible aux variations de la fréquence et des composants constitutifs du circuit

Ce dernier dispositif n'est donc pas une bonne solution pour une réalisation en technologie MMIC. En effet, le dispositif intégré est calibré à partir de la mesure d'étalons. Cet étalonnage est effectué pour un échantillon, et est considéré équivalent pour tous les autres dispositifs intégrés, quelle que soit la plaquette dans une technologie donnée. Il faut donc que les caractéristiques du dispositif soient indépendantes des variations des composants d'une plaquette à l'autre, ce qui n'est pas le cas en espèce.

Un autre document de l'art connu, US-A-4 001 681, décrit un voltmètre vectoriel pour mesurer la différence d'amplitude et de phase entre deux signaux sinusoïdaux de même fréquence.

L'objet de l'invention est la conception d'un dispositif de mesure en technologie monolithique intégrée micro-onde (MMIC) ou hybride intégrée micro-onde (MHMIC), pour une application à la mesure du rapport vectoriel entre deux signaux hyperfréquences de même pulsation.

Exposé de l'invention

L'invention propose un dispositif pour la mesure vectorielle de signaux hyperfréquences de même pulsation, du type jonction à six accès, comprenant un diviseur de puissance et un circuit de déphasage, deux des six accès de ce dispositif étant des accès de mesure aptes à être connectés à deux sources de signaux à caractériser, les quatre autres accès étant connectés à quatre détecteurs, caractérisé en ce que les deux bornes d'entrée du diviseur de puissance reçoivent le premier signal à caractériser ; en ce que les deux bornes d'un premier accès du circuit de déphasage, entre lesquelles est disposé un premier détecteur non adapté en impédance, reçoivent le second signal à caractériser; en ce que deux bornes d'une première sortie du diviseur de puissance sont reliées à deux bornes d'un second accès du circuit de déphasage, un second détecteur non adapté en impédance étant relié entre ces deux bornes ; en ce que le détecteur adapté en impédance est connecté entre les deux bornes d'une seconde sortie du diviseur de puissance; et en ce qu'un troisième détecteur non adapté en impédance est relié entre une première borne du premier accès du circuit de déphasage et une première borne du second accès du même circuit.

Le dispositif de l'invention peut être réalisé en technologie intégrée micro-onde ou hybride intégrée micro-onde.

Le diviseur de puissance est un diviseur résistif de puissance. Le détecteur adapté comprend un détecteur non-adapté en parallèle avec une résistance qui est l'impédance de référence des lignes de propagation hyperfréquence.

Le circuit de déphasage comprend au moins une cellule de déphasage consistant en un filtre passe-tout. Cette cellule de déphasage est une cellule en "T" formée de deux inductances au point milieu desquelles est connectée une capacité dont l'autre électrode est reliée à la masse.

Un détecteur non-adapté comprend, avantageusement, une diode, une capacité étant disposée entre chacune des électrodes de la diode et l'une des deux bornes d'entrée qui reçoit le signal d'entrée ; cette diode étant alimentée en continu par une tension délivrée par une alimentation disposée en série avec une première résistance de polarisation connectées entre la masse et l'anode de cette diode ; un filtre passe-bas étant connecté en série avec une seconde résistance de polarisation entre la masse et la cathode de cette diode. La tension détectée est obtenue aux bornes du filtre.

Un tel dispositif résout les problèmes posés par les dispositifs de l'art connu.

Il propose en effet un schéma électrique original de jonction à six accès pour la mesure vectorielle de signaux hyperfréquences de même pulsation. La bande passante du circuit est de l'ordre de trois octaves. Les pertes en puissances entre les accès sont réduites et la dimension du circuit est de l'ordre du mm$^2$.

L'intégration de ce dispositif de mesure permet la caractérisation du circuit MMIC "in situ" par implantation de ce dispositif dans le circuit MMIC à tester, ou dans les sondes des stations de mesure sous pointes. Une application avantageuse de ce dispositif est l'étude de l'interaction du rayonnement micro-onde avec la matière (matériaux, milieux biologiques) en microgravité car il peut être embarqué à bord de satellites, de ballons sondes, en raison de ses dimensions réduites. Une autre application avantageuse de ce dispositif est son intégration aux éléments rayonnants des antennes à balayage électronique. La détermination de la phase relative entre les signaux captés par les éléments rayonnants permet le pointage automatique de l'antenne dans la direction de la source.

Brève description des dessins

- La figure 1 illustre le dispositif de mesure de l'invention ;
- la figure 2 illustre un exemple de réalisation du dispositif de mesure de l'invention ;
- la figure 3 illustre un exemple de réalisation des détecteurs utilisés dans le dispositif de mesure de l'invention ;
- la figure 4 illustre la variation des centres $Q_i$ de cercles représentatifs dans le plan complexe $(V_{22'}/V_{11'})$ dans la bande de fréquence 500 MHz-3GHz.

Exposé détaillé de modes de réalisation

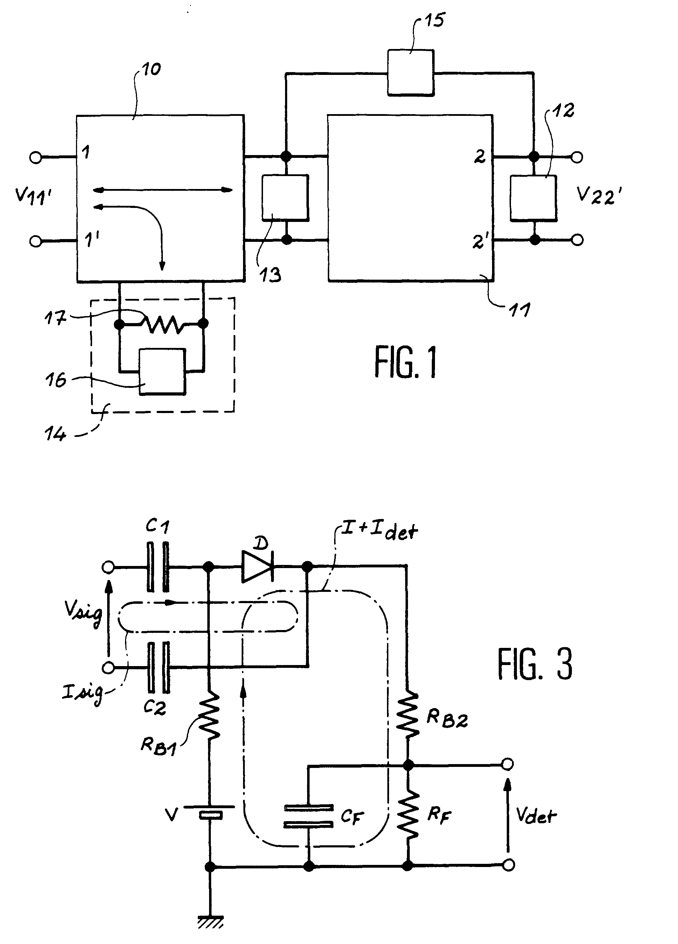

Le dispositif de mesure de l'invention, tel que représenté sur la figure 1, comprend un diviseur de puissance 10 et un circuit de déphasage 11.

Dans ce dispositif de mesure, les deux bornes d'entrée 1, 1' du diviseur de puissance 10 reçoivent le premier signal à caractériser $V_{11'}$.

Les deux bornes 2, 2' d'un premier accès du circuit de déphasage 11, entre lesquelles est disposé un premier détecteur 12, reçoivent le second signal à caractériser $V_{22'}$.

Deux bornes d'une première sortie du diviseur de puissance 10 sont reliées à deux bornes du second accès du circuit de déphasage 11, un second détecteur 13 étant relié entre ces deux bornes.

Un détecteur adapté 14 est connecté entre les deux bornes de la seconde sortie du diviseur de puissance 10.

Un troisième détecteur 15 est relié entre une première borne du premier accès du circuit de déphasage 11 et une première borne du second accès du même circuit 11.

Des caractéristiques essentielles de l'invention sont notamment le schéma électrique de la jonction à six accès de la figure 1 et l'utilisation de détecteurs "non adaptés".

Les accès de mesure notés 11' et 22' sont connectés aux deux sources de signaux à caractériser. Les quatre autres accès, notés ii' (i, i'=3, 4, 5, 6) sont connectés à quatre détecteurs 12, 13, 14, 15.

Le faible nombre de composants utilisés pour la réalisation du dispositif explique la large bande passante de fonctionnement du dispositif et la dimension réduite de celui-ci.

Le détecteur adapté 14 comprend un détecteur non adapté 16 en parallèle avec une résistance 17 telle que $Z_0=50\ \Omega$, qui est l'impédance de référence des lignes de propagation hyperfréquence. Le détecteur 16 et la résistance 17 constituent un détecteur "adapté" à l'impédance de référence: l'impédance interne du détecteur étant grande, l'impédance d'entrée du détecteur est donc globalement égale à $Z_0$.

Dans les dispositifs de l'art connu, comme ceux décrits dans les articles précités, tous les détecteurs sont adaptés. Dans le dispositif proposé, l'impédance interne des détecteurs 12, 13, 15 n'est pas transformée en une impédance égale à $Z_0$. Cette caractéristique permet de diminuer les pertes en puissance du dispositif.

Dans le schéma synoptique du dispositif de l'invention, illustré à la figure 1, en supposant que deux signaux hyperfréquences $V_{11'}$, $V_{22'}$ soient présents aux accès 11', 22', les tensions $V_{ii'}$, (i=3, 4, 5, 6) aux bornes des détecteurs sont une combinaison linéaire des tensions $V_{11'}$, $V_{22'}$.

$V_{ii'}=\alpha_i V_{11'}+\beta_i V_{22'}$, avec $\alpha_i$, $\beta_i$ des constantes complexes indépendantes des tensions à caractériser $V_{11'}$, $V_{22'}$.

Les détecteurs fournissent aux accès ii' du circuit des tensions continues proportionnelles au module carré des tensions alternatives $V_{ii'}$. La mesure de ces tensions continues de sortie permet de déterminer le rapport vectoriel des tensions $V_{11'}$, $V_{22'}$ après un traitement mathématique approprié des données de mesure. Le schéma électrique proposé permet de déterminer le rapport $V_{11'}/V_{22'}$ sans ambiguïté dans la bande de fréquence 500 MHz-3 GHz. Cette bande de fréquence est fixée par celle du circuit de déphasage.

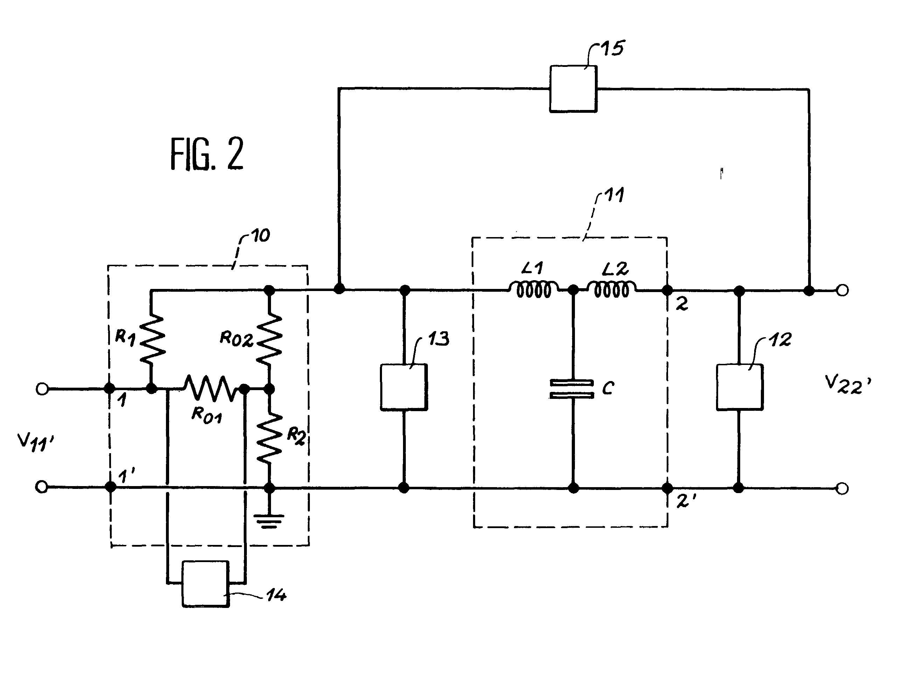

La figure 2 représente le schéma électrique d'une réalisation du dispositif de l'invention.

Les résistances $R_1$, $R_2$ $R_{01}$ et $R_{02}$ constituent le diviseur de puissance. A la condition que le produit de $R_1$ et $R_2$ soit égal au carré de $R_{02}$, l'impédance d'entrée d'accès 11' est égale à l'impédance de référence $Z_0$=50 Ω. Les valeurs de ces résistances sont fixées afin d'obtenir une atténuation de 3 dB entre l'accès 11' et les bornes du détecteur 13, ce qui est la valeur optimale dans la technologie MMIC choisie. Les inductances $L_1$, $L_2$ et la capacité C constituent un filtre passe-bas et réalisent la fonction du circuit de déphasage. On peut la remplacer par un filtre passe-tout. Les valeurs de ces éléments sont calculés afin d'obtenir le déphasage requis (60°) dans la bande de fréquence et l'impédance d'entrée de l'accès égale à 50 Ω.

Si l'on utilise plusieurs cellules de déphasage $L_1$, $L_2$, C du type de celle représentée à la figure 2 : on obtient un dispositif pouvant fonctionner sur une décade par exemple de 1 à 10 GHz.

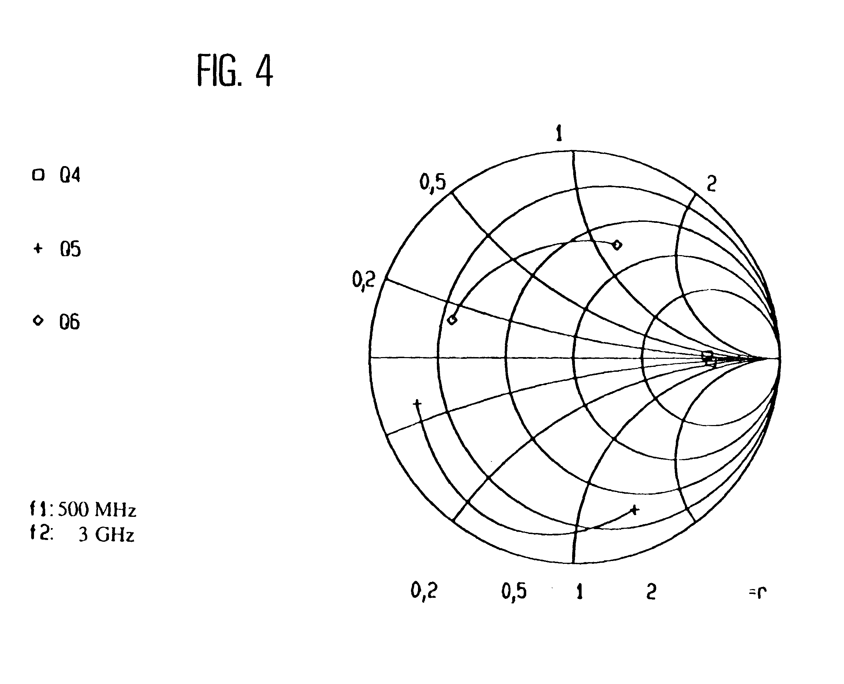

Un schéma électrique de détecteurs non adaptés est présenté sur la figure 3.

Dans ce circuit, il n'y a pas de masse commune entre l'alimentation continue et l'alimentation alternative.

Un détecteur non adapté comprend une diode D, une capacité $C_1$ ou $C_2$ étant disposée entre chacune des électrodes de la diode D et l'une des deux bornes d'entrée qui reçoit un signal d'entrée $V_{sig}$. Cette diode est alimentée en continu par une tension délivrée par une alimentation V disposée en série avec une première résistance de polarisation $R_{B1}$, connectées entre la masse et l'anode de cette diode D ; un filtre passe-bas ($R_F$, $C_F$) étant connecté en série avec une seconde résistance de polarisation $R_{B2}$ entre la masse et la cathode de cette diode.

La tension détectée $V_{det}$ est obtenue aux bornes du filtre.

Il y a dans ce circuit deux boudes de courant :

- une première boude de courant alternatif : $I_{sig}$,
- une seconde boude de courant continu : $I+I_{det}$.

La topologie a été choisie afin d'obtenir un chemin continu pour le courant du signal hyperfréquence ($I_{sig}$) et le courant continu ($I+I_{det}$). Les diodes sont de type SCHOTTKY. Les capacités de liaisons $C_1$, $C_2$ permettent de découpler les signaux continu et hyperfréquences. Les résistances $R_{B1}$, $R_{B2}$ permettent d'isoler les signaux hyperfréquences de la masse. La résistance $R_F$ et la capacité $C_F$ constituent un filtre passe-bas à la sortie duquel est disponible la tension continue.

Dans un exemple de réalisation de l'invention, on considère les valeurs suivantes :
**pour le dispositif de l'invention :**

$R_1$ = 20 Ω
$R_2$ = 120 Ω
$R_{01}$ = 50 Ω
$R_{02}$ = 50 Ω
$L_1 = L_2$ = 1,9 nH
C = 1,5 pF

**pour chaque détecteur :**

$C_1 = C_2$ = 3pF
$R_{B1} = R_{B2}$= 1kΩ
$C_F$ = 1,3 pF
$R_F$ = 10kΩ
V = 0,74 V.

Les résultats théoriques prévoient, dans la bande de fréquence 500 MHz-3 GHz une perte en transmission entre les deux accès de mesure, noté $L_{12}$, égale à +3 dB, et des pertes en transmission égales à +12 dB, dans le pire des cas, entre ces mêmes accès de mesure et les quatre autres où sont connectés les détecteurs. Ces pertes sont notées $L_{ji}$ (j=1, 2 et i=3, 4, 5, 6).

Les résultats simulés à partir des modèles électriques des composants d'une fonderie donnée sont indiqués dans le tableau ci-dessous dans la même bande de fréquence.

| Valeurs | Typique | Pire cas |
|---------|---------|----------|
| $L_{12}$ | 6 dB | 7,2 dB |
| $L_{ij}$ | 5 dB | 15 dB |

La surface totale du circuit est égale à 1,2 mm² avec les quatre diodes de détection connectées à quatre des six accès de la jonction. En supposant que les valeurs des composants du circuit varient de 10%, les caractéristiques du circuit évoluent du même ordre de grandeur.

D'autre part, les caractéristiques de la jonction permettent d'obtenir une incertitude minimale sur la mesure. En effet, en notant $Q_i = (\alpha_i/\beta_i)$, i=4,5,6 avec $\alpha_i$, $\beta_i$ des constantes complexes indépendantes des tensions à caractériser $V_{11'}$, $V_{22'}$, et en supposant que la constante $\beta_3$ est nulle, on peut montrer que le rapport de ces mêmes tensions ($V_{11'}/V_{22'}$) peut être déterminé graphiquement à partir du point d'intersection de trois cercles de centre $Q_i$ et de rayon

$$\frac{|V_{ii'}|}{|V_{33'}|} \frac{|\alpha_3|}{|\beta_i|}$$

égal au produit du rapport des modules des tensions $V_{ii'}$ et $V_{33'}$, et du rapport des modules des constantes $\alpha_3$ et $\beta_i$, dans le plan complexe ($V_{22'}/V_{11'}$).

Les résultats simulés montrent que dans le pire cas la constante $\beta_3$ est toujours inférieure à $10^{-3}$ Un autre critère de qualité des jonctions à six accès pour la mesure du rapport vectoriel des signaux $V_{22'}$ et $V_{11'}$ est d'obtenir une équi-répartition des centres $Q_i$ des cercles dans le plan complexe ($V_{22'}/V_{11'}$), soit un module constant et un déphasage relatif de 120° entre les centres $Q_i$ des cercles. Les résultats simulés des centres $Q_i$ sont représentés graphiquement sur la figure 4 dans le plan complexe $V_{22'}/V_{11'}$, et sous forme tabulées sur le tableau donné ci-dessous dans la bande de fréquence 500 MHz-3GHz.

| FREQ-GHz | Q4 MAG | Q4 ANG | Q5 MAG | Q5 ANG | Q6 MAG | Q6 ANG |
|----------|--------|--------|--------|--------|--------|--------|
| 0.50000 | 0.671 | -1.376 | 0.804 | -163.293 | 0.625 | 163.155 |
| 0.60000 | 0.670 | -1.366 | 0.808 | -159.885 | 0.621 | 159.826 |
| 0.70000 | 0.668 | -1.368 | 0.814 | -156.520 | 0.617 | 156.512 |
| 0.80000 | 0.667 | -1.377 | 0.821 | -153.202 | 0.612 | 153.221 |
| 0.90000 | 0.666 | -1.390 | 0.828 | -149.930 | 0.607 | 149.956 |
| 1.00000 | 0.664 | -1.404 | 0.836 | -146.703 | 0.601 | 146.718 |
| 1.10000 | 0.663 | -1.414 | 0.844 | -143.515 | 0.596 | 143.505 |
| 1.20000 | 0.662 | -1.419 | 0.852 | -140.361 | 0.590 | 140.312 |
| 1.30000 | 0.660 | -1.415 | 0.860 | -137.232 | 0.584 | 137.133 |
| 1.40000 | 0.659 | -1.401 | 0.868 | -134.118 | 0.579 | 133.959 |
| 1.50000 | 0.658 | -1.373 | 0.875 | -131.007 | 0.574 | 130.782 |
| 1.60000 | 0.656 | -1.331 | 0.881 | -127.884 | 0.569 | 127.590 |
| 1.70000 | 0.655 | -1.272 | 0.886 | -124.734 | 0.565 | 124.370 |
| 1.80000 | 0.653 | -1.194 | 0.890 | -121.537 | 0.562 | 121.107 |
| 1.90000 | 0.652 | -1.096 | 0.892 | -118.273 | 0.559 | 117.783 |
| 2.00000 | 0.651 | -0.976 | 0.893 | -114.918 | 0.557 | 114.378 |

(suite)

| FREQ-GHz | Q4 MAG | Q4 ANG | Q5 MAG | Q5 ANG | Q6 MAG | Q6 ANG |
|---|---|---|---|---|---|---|
| 2.10000 | 0.650 | -0.833 | 0.891 | -111.445 | 0.556 | 110.870 |
| 2.20000 | 0.649 | -0.667 | 0.888 | -107.821 | 0.555 | 107.234 |
| 2.30000 | 0.648 | -0.476 | 0.883 | -104.012 | 0.556 | 103.440 |
| 2.40000 | 0.648 | -0.263 | 0.876 | -99.977 | 0.558 | 99.453 |
| 2.50000 | 0.647 | -0.027 | 0.866 | -95.670 | 0.561 | 95.238 |
| 2.60000 | 0.648 | 0.228 | 0.855 | -91.039 | 0.565 | 90.751 |
| 2.70000 | 0.648 | 0.499 | 0.842 | -86.026 | 0.570 | 85.945 |
| 2.80000 | 0.649 | 0.782 | 0.828 | -80.566 | 0.576 | 80.769 |
| 2.90000 | 0.651 | 1.069 | 0.813 | -74.596 | 0.583 | 75.166 |
| 3.00000 | 0.654 | 1.353 | 0.798 | -68.050 | 0.590 | 69.084 |

## Revendications

1. Dispositif pour la mesure vectorielle de signaux hyperfréquences de même pulsation, du type jonction à six accès, comprenant un diviseur de puissance (10) et un circuit de déphasage (11), deux des six accès de ce dispositif étant des accès de mesure aptes à être connectés à deux sources de signaux à caractériser, les quatre autres accès étant connectés à quatre détecteurs, **caractérisé en ce que** les deux bornes d'entrée du diviseur de puissance (10) reçoivent le premier signal à caractériser ($V_{11'}$) ; **en ce que** les deux bornes d'un premier accès du circuit de déphasage (11), entre lesquelles est disposé un premier détecteur non adapté en impédance (12), reçoivent le second signal à caractériser ($V_{22'}$) ; **en ce que** deux bornes d'une première sortie du diviseur de puissance (10) sont reliées à deux bornes d'un second accès du circuit de déphasage (11), un second détecteur non adapté en impédance (13) étant relié entre ces deux bornes ; **en ce que** le détecteur adapté en impédance (14) est connecté entre les deux bornes d'une seconde sortie du diviseur de puissance (10) ; et **en ce qu'**un troisième détecteur non adapté en impédance (15) est relié entre une première borne du premier accès du circuit de déphasage (11) et une première borne du second accès du même circuit.

2. Dispositif selon la revendication 1 , **caractérisé en ce qu'**il est réalisé en technologie monolithique intégrée micro-onde ou hybride intégrée micro-onde.

3. Dispositif selon la revendication 1, **caractérisé en ce que** le diviseur de puissance (10) est un diviseur résistif de puissance ($R_1$, $R_2$, $R_{01}$, $R_{02}$).

4. Dispositif selon la revendication 1, **caractérisé en ce que** le détecteur adapté comprend un détecteur non adapté (16) en parallèle avec une résistance (17) qui est l'impédance de référence des lignes de propagation hyperfréquence.

5. Dispositif selon la revendication 1, **caractérisé en ce que** le circuit de déphasage comprend au moins une cellule (11) de déphasage consistant en un filtre passe-tout.

6. Dispositif selon la revendication 5, **caractérisé en ce que** cette cellule de déphasage est une cellule en "T" formée de deux inductances ($L_1$, $L_2$) au point milieu desquelles est connectée une capacité (C) dont l'autre électrode est reliée à la masse.

7. Dispositif selon l'une quelconque des revendications précédentes, **caractérisé en ce qu'**un détecteur non adapté comprend une diode (D), une capacité ($C_1$ ou $C_2$) étant disposée entre chacune des électrodes de la diode (D) et l'une des deux bornes d'entrée qui reçoit un signal d'entrée($V_{sig}$), cette diode étant alimentée en continu par une tension délivrée par une alimentation (V) disposée en série avec une première résistance de polarisation ($R_{B1}$), connectée entre la masse et l'anode de cette diode (D), un filtre passe-bas ($R_F$, $C_F$) étant connecté en série avec une seconde résistance de polarisation ($R_{B2}$) entre la masse et la cathode de cette diode, la tension détectée

($V_{det}$) étant obtenue aux bornes du filtre.

**Patentansprüche**

1. Vorrichtung zum vektoriellen Messen ultrahochfrequenter Signale mit gleichem Impuls vom Typ "Sechs-Port-Kopplung", die einen Leistungsteiler (10) und einen Phasenschieberkreis (11) umfaßt, wobei zwei der sechs Ports dieser Vorrichtung Meßports sind, die für den Anschluß an zwei Quellen für zu bewertende Signale geeignet sind, während die vier anderen Ports an vier Signalgeber angeschlossen sind, **dadurch gekennzeichnet, daß** die beiden Eingangsklemmen des Leistungsteilers (10) das erste zu bewertende Signal ($V_{11'}$) erhalten; daß die beiden Klemmen eines ersten Ports des Phasenschieberkreises (11), zwischen die ein erster nicht impedanzangepaßter Signalgeber (12) eingebracht wurde, das zweite zu bewertende Signal ($V_{22'}$) erhalten; daß die beiden Klemmen eines ersten Ausgangs des Leistungsteilers (10) mit zwei Klemmen eines zweiten Ports des Phasenschieberkreises (11) verbunden sind, wobei ein zweiter nicht impedanzangepaßter Signalgeber (13) zwischen diesen beiden Klemmen angeschlossen ist; daß der impedanzangepaßte Signalgeber (14) zwischen den beiden Klemmen eines zweiten Ausgangs des Leistungsteilers (10) angeschlossen ist; und daß ein dritter nicht impedanzangepaßter Signalgeber (15) zwischen einer ersten Klemme des ersten Ports des Phasenschieberkreises (11) und einer ersten Klemme des zweiten Ports desselben Kreises angeschlossen ist.

2. Vorrichtung gemäß Anspruch 1, **dadurch gekennzeichnet, daß** sie auf der monolithischen integrierten Mikrowellen-Technologie (MMIC) oder der hybriden integrierten Mikrowellen-Technologie (MHMIC) basiert.

3. Vorrichtung gemäß Anspruch 1, **dadurch gekennzeichnet, daß** es sich bei dem Leistungsteiler (10) um einen Widerstandsleistungsteiler ($R_1$, $R_2$, $R_{01}$, $R_{02}$) handelt.

4. Vorrichtung gemäß Anspruch 1, **dadurch gekennzeichnet, daß** der angepaßte Signalgeber einen nicht angepaßten Signalgeber (16) in Parallelschaltung mit einem Widerstand (17) umfaßt, der der Bezugsimpedanz der Ultrahochfrequenz-Ausbreitungslinien entspricht.

5. Vorrichtung gemäß Anspruch 1, **dadurch gekennzeichnet, daß** der Phasenschieberkreis mindestens eine Phasenschieberzelle (11) umfaßt, die aus einem All(frequenz)paßfilter besteht.

6. Vorrichtung gemäß Anspruch 5, **dadurch gekennzeichnet, daß** es sich bei dieser Phasenschieberzelle um eine "T"-Zelle handelt, die aus zwei induktiven Widerständen ($L_1$, $L_2$) gebildet wird, in deren Mittelpunkt ein C-Glied (C) angeschlossen ist, dessen andere Elektrode mit der Masse verbunden ist.

7. Vorrichtung gemäß einem der vorstehenden Ansprüche, **dadurch gekennzeichnet, daß** ein nicht angepaßter Signalgeber eine Diode (D) umfaßt, wobei ein C-Glied ($C_1$ oder $C_2$), zwischen jede der Elektroden der Diode (D) und eine der beiden Eingangsklemmen, die ein Eingangssignal ($V_{sig}$) erhält, eingebracht ist, wobei diese Diode kontinuierlich durch eine Stromversorgung (V) mit Spannung versorgt wird, die mit einem ersten Polarisierungswiderstand ($R_{B1}$) in Reihe geschaltet ist, der zwischen Masse und der Anode dieser Diode (D) angeschlossen ist, wobei ein Tiefpaßfilter ($R_F$, $C_F$) mit einem zweiten Polarisierungswiderstand ($R_{B2}$) zwischen Masse und der Kathode dieser Diode in Reihe geschaltet ist und wobei die gemessene Spannung ($V_{det}$) an den Klemmen des Filters ermittelt wird.

**Claims**

1. Device for the vector measurement of ultra-high frequency signals of the same angular frequency, of the six port junction type, comprising a power divider (10) and a phase shifting circuit (11), two of the six ports of said device being measuring ports connectable to two sources of signals to be characterized, the four other ports being connected to four detectors, **characterized in that** the two input terminals of the power divider (10) receive the first signal to be characterized ($V_{11'}$), that the two terminals of a first port of the phase shifting circuit (11), between which is located a first detector (12) which is not impedance matched, receive the second signal to be characterized ($V_{22'}$), that two terminals of a first output of the power divider (10) are connected to two terminals of a second port of the phase shifting circuit (11), a second detector (13) which is not impedance matched being connected between these two terminals, that the impedance matched detector (14) is connected between the two terminals of a second output of the power divider (10) and **in that** a third detector (15) which is not impedance matched is connected between a first terminal of the first port of the phase shifting circuit (11) and a first terminal of the first port of the same circuit.

2. Device according to claim 1, **characterized in that** it is produced in monolithic integrated or monolithic hybrid integrated microwave technology.

3. Device according to claim 1, **characterized in that** the power divider (10) is a resistive power divider ($R_1$, $R_2$, $R_{01}$, $R_{02}$).

4. Device according to claim 1, **characterized in that** the matched detector comprises an unmatched detector (16) in parallel with a resistor (17), which is the reference impedance of the ultra-high frequency propagation lines.

5. Device according to claim 1, **characterized in that** the phase shifting circuit comprises at least one phase shifting cell (11) consisting of an all-pass filter.

6. Device according to claim 5, **characterized in that** said phase shifting cell is a T cell formed by two inductances ($L_1$, $L_2$) at the centre point of which is connected a capacitor (C), whose other electrode is connected to earth.

7. Device according to any one of the preceding claims, **characterized in that** an unmatched detector comprises a diode (D), a capacitor ($C_1$ or $C_2$) being located between each of the electrodes of the diode (D) and one of the two input terminals receiving an input signal (Vsig), said diode being continuously supplied by a voltage delivered by a power supply (V) in series with a first polarization resistor ($R_{B1}$) connected between earth and the anode of said diode (D), a low-pass filter ($R_F$, $C_F$) being connected in series with a second polarization resistor ($R_{B2}$) between earth and the cathode of said diode, the detected voltage ($V_{det}$) being obtained at the filter terminals.

FIG. 1

FIG. 3

FIG. 2

EP 0 633 477 B1

# FIG. 4

□  Q4

+  Q5

◇  Q6

f1: 500 MHz
f2:   3 GHz

EP 0 633 477 B1